# EUROPEAN PATENT SPECIFICATION

(11) **EP 0 343 731 B1**
(45) Date of publication and mention of the grant of the patent: **03.01.1996**
(21) Application number: 89201279.0
(22) Date of filing: 22.05.1989
(51) Int. Cl.: G05F 1/573

(54) **Unity-gain current-limiting circuit**
Strombegrenzungsschaltung mit Einheitsverstärkung
Circuit limiteur de courant à gain unitaire

(30) Priority: 26.05.1988 US 199063
(43) Date of publication of application: 29.11.1989
(73) Proprietor: Philips Electronics N.V., NL-5621 BA Eindhoven (NL)
(72) Inventor: Blauschild, Robert Alan, NL-5656 AA Eindhoven (NL)
(74) Representative: Peters, Rudolf Johannes

(56) References cited:
- US-A- 3 524 124
- IBM TECHNICAL DISCLOSURE BULLETIN, vol. 17, no. 3, August 1974, page 751, New York, US; D.M. TAUB: "Current-limiting circuit"
- APPLICATIONS OF ANALOG INTEGRATED CIRCUITS, 1985, pages 35-42, Soclof; "Voltage regulator protection circuitry"
- ELECTRONIC COMPONENTS AND APPLICATIONS, vol. 1, no. 2, February 1979, pages 120-121; "Charge regulator"

## Description

The invention relates to an electronic circuit for preventing an output current flowing through an output line from exceeding a specified value of an input current flowing through an input line.

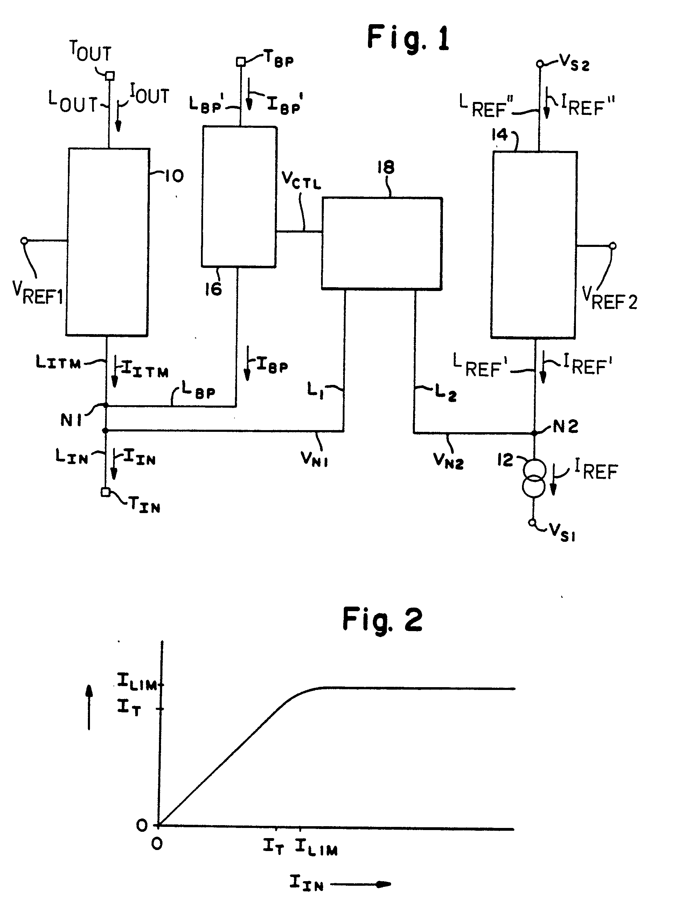

Such an electronic circuit is suitable for use in semiconductor devices and,more particularly,in circuits that limit the maximum value of a current and is known from Soclof, Applications of Analog Integrated Circuits (Prentice-Hall: 1985),pp.35-42,Fig.2-3.

Current-limiting circuitry is employed in many semiconductor devices to conserve power or to achieve a predetermined maximum output current for a variable input current.For example, Soclof describes how voltage regulators use current-limiting circuits to avoid excessive power dissipation that could lead to overheating and permanent damage.The current limiters in Soclof provide a current gain that is much greater than unity at values of the input current below which significant current limiting occurs.

A current-limiting circuit that achieves a current gain largely equal to one is desirable in certain applications.In such a device,the output current ideally equals the input current up to a specified value of the input current above which the output current is fixed at the specified value of the input current. Designing a simple unity-gain circuit that comes close to the ideal current transfer characteristic presents a significant challenge. It is often desirable that the circuit operate in a largely temperature-independent manner. This increases the challenge considerably.

It is an object of the invention to provide a current-limiting circuit wherein the output current substantially equals the input current up to a specified value of the input current above which the output current is fixed at the specified value of the input current.An electronic circuit as specified in the opening paragraph is according to the invention characterized by
a main channel, including the output line and an intermediate line coupled to the input line by way of a first node at which a first nodal voltage is present, for providing a current path between the intermediate and output lines, the intermediate line carrying a current substantially equal to the output current;
a current source, coupled between a first voltage supply and a second node at which a second nodal voltage is present, for supplying a reference current;
a reference channel for providing a current path between the second node and a second voltage supply;
bypass means coupled to the first node for providing a current shunt away from the main channel; and
control means coupled to the nodes for supplying the bypass means with a control signal that causes a portion of the input current to be diverted away from the intermediate line and through the bypass means when the input current achieves a prescribed relationship to the reference current, the diverted current portion progressively increasing as the input current increases such that the output current does not pass the specified value of the input current.

This electronic circuit is a highly accurate current-limiting circuit that prevents the output current flowing through the output line from exceeding a specified value of the input current flowing through the input line. The current gain below the specified value of the input current is very close to unity. The circuit is formed with a main channel, a current source, a reference channel, a bypass means, and a control means. The main channel provides a current path between the output line and the intermediate line coupled to the input line by way of the first node at which the first nodal voltage is present. The intermediate line carries an intermediate current largely equal to the output current. The main channel preferably contains a first channel device that causes the output current to vary in a prescribed way as a function of the first nodal voltage and a first reference voltage. The output current usually increases as the magnitude of the difference between the two voltages increases.

The current source, which is coupled between a first voltage supply and a second node at which a second nodal voltage is present, supplies a reference current. The reference channel provides a current path between the second node and a second voltage supply. The reference channel preferably contains a second channel device that largely sets the second nodal voltage at a value dependent on the reference current and a second reference voltage.

The bypass means is coupled to the first node to provide a current shunt away from the main channel. The control means, which is coupled to the two nodes, supplies the bypass means with a control signal that causes a portion of the input current to be diverted away from the intermediate line and through the bypass device when the input current achieves a prescribed relationship to the reference current. As the input current increases, the diverted current portion progressively increases in such a way that the output current does not pass the specified value of the input current.

More specifically, the control signal switches between a pair of opposite states depending on the amount of difference between the nodal voltages. Generation of the control signal at one of the states disables the bypass means so that none of the input current flows through it. The output current largely equals the input current. Generation of the control signal at the other state enables the bypass means so as to permit the requisite portion of the input current to flow through it. The control means is usually implemented with a differential amplifier and a positive feedback means in order to produce a sharp transition between the unity-gain and current-limited conditions.

The first channel device is preferably formed with a first bipolar transistor having a base responsive to the first reference voltage, an emitter coupled through a first resistor to the intermediate line, and a collector coupled to the output line. The second channel device is then likewise formed with a like-polarity second bipolar transistor having a base responsive to the second reference voltage, an emitter coupled through a second resistor to the second node, and a collector coupled to the second voltage supply. The two reference voltages are typically the same. In this case, the circuit can be made to operate in a substantially temperature-independent manner by setting the ratio of the value of the second resistor to the value of the first resistor equal to the ratio of the emitter area of the first transistor to the emitter area of the second transistor. The invention will now be described with reference to the accompanying drawings in which:
Fig. 1 is a block diagram of a unity-gain current-limiting circuit in accordance with the invention.
Fig. 2 is a graph for output current as a function of input current for the circuit in Fig. 1.
Fig. 3 is a circuit diagram for a general implementation of the circuit in Fig. 1.
Fig. 4 is a circuit diagram for a preferred embodiment of the circuit in Fig. 3.

Like reference symbols are employed in the drawings and in the description of the preferred embodiments to represent the same or very similar item or items. The arrows in Figs. 1, 3, and 4 indicate the directions of positive current flow.

Referring to the drawings, Fig. 1 illustrates the basic features of a current-limiting circuit configured according to the teachings of the invention. The circuit prevents an output current L_{OUT} from exceeding a specified value I_{LIM} of an input current I_{IN}. Output current I_{OUT} flows through an output line L_{OUT} connected to a circuit output terminal T_{OUT}. Input current I_{IN} similarly flows through an input line L_{IN} connected to a circuit input terminal T_{IN}.

The circuit in Fig. 1 is connected between a source of a first supply voltage V_{S1} and a source of a second supply voltage V_{S2}. The V_{S1} and V_{S2} supplies provide operating power to the circuit. The principal components of the circuit are a first channel device 10 controlled by a fixed first reference voltage V_{REF1}, a current source 12 that supplies a reference current I_{REF}, a second channel device 14 controlled by a fixed second reference voltage V_{REF2}, a current bypass device 16, and a bypass control system 18.

Channel device 10 provides a current path between output line L_{OUT} and an intermediate line L_{ITM} connected through a first node N1 to input line L_{IN}. An intermediate current I_{ITM} flows on intermediate line L_{ITM}. The current path through device 10 is of such a nature that current I_{ITM} is largely equal to current I_{OUT}. I_{ITM} is preferably within 5% of I_{OUT} and typically differs from I_{OUT} by 1% or less. The combination of line L_{ITM}, device 10, and line L_{OUT} thereby forms a main channel for current I_{OUT}.

A first nodal voltage V_{N1} is present at node N1. Current I_{OUT} depends strongly on voltage V_{N1}. More precisely, channel device 10 causes current I_{OUT} to vary in a prescribed manner as a function of voltages V_{N1} and V_{REF1.} The relationship among these parameters usually has the characteristic that I_{OUT} increases as the magnitude of the voltage difference between V_{N1} and V_{REF1} increases.

Current source 12 is connected between the V_{S1} supply and a second node N2. A second nodal voltage V_{N2} is present at node N2. Source 12 is typically implemented in such a manner that current I_{REF} is substantially independent of temperature and the overall power supply voltage |V_{S2} - V_{S1}|. However, I_{REF} can be made to vary with either or both of these parameters.

Channel device 14 is part of a reference channel that provides a current path between node N2 and the V_{S2} supply. The remainder of the reference channel consists of interconnecting lines L_{REF}' and L_{REF}" which carry respectively largely equal currents I_{REF}' and I_{REF}", The difference between I_{REF}' and I_{REF}" is preferably no more than 5% and is typically 1% or less. For the reason given below, current I_{REF}' is substantially equal to reference current I_{REF} supplied by current source 12. This enables device 14 to set voltage V_{N2} at a value dependent on current I_{REF} and voltage V_{REF2}.

Bypass device 16 provides a shunt for selectively diverting a portion of current I_{IN} away from the main channel and through a circuit bypass terminal T_{BP}. Lines L_{BP} and L_{Bp}' connect device 16 respectively to node N1 and terminal T_{BP}. When device 16 is enabled (or activated), largely equal bypass currents I_{BP} and I_{Bp}' flow respectively on lines L_{BP} and L_{BP' .} Currents I_{BP} and I_{BP}' represent the diverted portion of current I_{IN}. I_{BP}' is preferably within 5% of I_{BP} and typically differs from I_{BP} by 1% or less. Device 16 performs the current shunting when current I_{IN} achieves a prescribed relationship to current I_{REF}. For example, if channel devices 10 and 14 are substantially identical, shunting occurs when I_{IN} is greater than I_{REF}.

Control system 18 supplies device 16 with a control signal V_{CTL} that regulates the shunting. Control signal V_{CTL} switches between a pair of opposite voltage states, referred to here as the high and low states, depending on the amount (i.e., the magnitude and sign) of the difference between voltages V_{N1} and V_{N2}. The shunting is initiated when signal V_{CTL} goes to the high state and is terminated when signal V_{CTL} returns to the low state. The high state may represent either a high voltage condition or a low voltage condition depending on whether V_{S2} is greater than or less than V_{S1}. Similar comments apply to the low state.

Voltages V_{N1} and V_{N2} are supplied to control system 18 from nodes N1 and N2 by way of lines L₁ and L₂ that carry bias currents much smaller than currents I_{REF} and I_{LIM}. It is for this reason that I_{REF}' is substantially equal to L_{REF}. During the time that signal V_{CTL} is at the high state (so as to enable bypass device 16), control system 18 receives negative feedback from device 16 by way of lines L_{BP} and L₁. System 18 operates in such a way that the negative feedback prevents the magnitude of the difference between voltages V_{N1} and V_{N2} from becoming very large.

With the foregoing in mind, the circuit components interact as follows to accomplish the current-limiting function. Let "I_{T}" represent the value of current I_{IN} at which shunting begins. Assume (for example) that V_{S2} is greater than V_{S1}. The various currents then flow in the directions indicated in Fig. 1. Fig. 2 shows how I_{OUT} varies with I_{IN}.

If I_{IN} is below I_{T}, V_{N1} is greater than V_{N2}. In response, control system 18 supplies signal V_{CTL} at a value that falls into a voltage range representing the low state. This disables (or deactivates) bypass device 16. Substantially none of I_{IN} flows through device 16. Neglecting the small bias current on line L₁, I_{ITM} is substantially equal to I_{IN}. Current I_{OUT} thus largely equals I_{IN}. See the left half of Fig. 2. The current gain --i.e., I_{OUT}/I_{IN} -- is very close to one.

Increasing I_{IN} causes I_{OUT} to increase. Channel device 10 reduces V_{N1} in response to the increase in I_{OUT}. V_{N1} drops to a value close to V_{N2} when I_{IN} reaches transition value I_{T}. V_{N1} may be slightly greater than or slightly less than V_{N2} at this point depending on the internal construction of control system 18. The magnitude of the voltage difference between V_{N1} and V_{N2} is usually no more than 60 millivolts when I_{IN} equals I_{T}.

A slight further increase in I_{IN} and a consequent slight further decrease in V_{N1} causes control system 18 to produce signal V_{CTL} at a value falling into a voltage range representing the high state. Bypass device 16 becomes active. This allows (non-zero) portion I_{BP} of current I_{IN} to be diverted away from line L_{ITM} and along line L_{BP} through device 16.

As I_{IN} continues to increase beyond I_{T}, I_{BP} progressively increases in such a way that I_{OUT} does not pass limiting value I_{LIM}. More particularly, the manner in which components 16 and 18 are arranged allows I_{BP} to change by a relatively large amount in response to a small change in the difference between V_{N1} and V_{N2}. The negative feedback through device 16 controls the difference between V_{N1} and V_{N2}. (Interaction between control system 18 and channel device 14 typically causes V_{N2} to rise slightly). In turn, device 10 prevents current I_{OUT} from passing I_{LIM}. The resulting current profile is shown in the right half of Fig. 2.

The sharpness of the transition between the unity-gain and fully-limited conditions is essentially represented by the difference between I_{T} and I_{LIM}. This difference is, in turn, determined principally by the gain of the transfer function through components 18 and 16. using relatively simple configurations for components 16 and 18, the difference between I_{T} and I_{LIM} can be *5%* or less to give a sharp transfer curve.

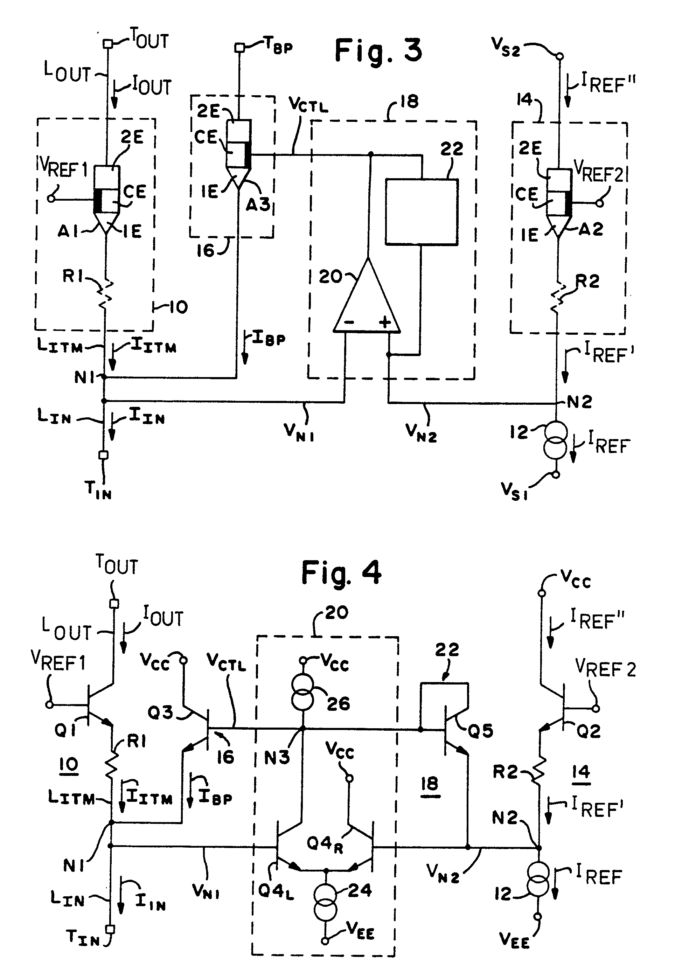

Turning to Fig. 3, it shows internal details for a general embodiment to the current-limiting circuit in Fig. 1. The embodiment in Fig. 3 uses several three-electrode amplifiers identified by reference symbols beginning with the letter "A". Each such Ai amplifier has a first flow electrode (1E), a second flow electrode (2E), and a control electrode (CE) for controlling current flow between the flow electrodes (1E and 2E). Charge carriers, either electrons or holes, that move between the flow electrodes of each Ai amplifier originate at its first flow electrode and terminate at its second flow electrode. The current (if any) flowing in the control electrode is much smaller than that otherwise moving between the flow electrodes.

Each Ai amplifier is typically a single transistor. In the case of a bipolar transistor, its emitter, collector, and base are respectively the first, second, and control electrodes. These are the source, drain, and gate, respectively, for a field-effect transistor of either the insulated-gate or junction type.

Each Ai amplifier could, however, be formed with more electronic elements than just a single transistor. One example is a bipolar Darlington circuit in which the emitter of an input transistor drives the base of a trailing transistor. In this example, the control electrode of the Ai amplifier is (connected to) the base of the input transistor, while the first and second electrodes are (connected to) the emitter and collector of the trailing transistor.

Certain of the Ai amplifiers are "like-configured". This means that they have corresponding elements interconnected in the same way and that each set of corresponding elements is of the same semiconductor polarity. For example, two of the Ai amplifiers are like-configured if both are NPN transistors (even though the emitter areas are different), but not if they are complementary transistors. Likewise two Darlington circuits are like-configured as long as the input transistors are of the same polarity and the trailing transistors are of the same polarity even if it is different from that of the input transistors.

Channel devices 10 and 14 in Fig. 3 respectively center around like-configured three-electrode (always-on) amplifiers A1 and A2 whose control electrodes are respectively responsive to voltages V_{REF1} and V_{REF2}. The first and second electrodes of amplifier A1 are respectively coupled to lines L_{ITM} and L_{OUT}. The first and second electrodes of amplifier A2 are respectively coupled to node N2 and the V_{S2} supply. Device 10 may have a first resistor R1 connected between node N1 and the first electrode of amplifier A1. If so, device 14 has a second resistor R2 connected between node N2 and the first electrode of amplifier A2.

Bypass device 16 is formed with a three-electrode switching amplifier A3 whose control electrode is responsive to signal V_{CTL}. Amplifier A3 has its first and second electrodes respectively connected to node N1 and terminal T_{BP}. Amplifier A3 turns on when signal V_{CTL} goes to the high state, and vice versa.

Control system 18 consists of a differential amplifier 20 and a feedback device 22. Differential amplifier 20 supplies signal V_{CTL} from a node N3 at its output by amplifying the difference between voltages V_{N1} and V_{N2} respectively supplied to its inverting and non-inverting inputs. Device 22 provides positive feedback from the output of amplifier 20 to its non-inverting input. The positive feedback increases the gain of system 18. In turn, this reduces the magnitude of the difference between voltages V_{N1} and V_{N2} at the fully limited condition.

Fig. 4 illustrates a preferred bipolar implementation for the circuit of Fig. 3. Voltages V_{S1} and V_{S2} are low and high supply voltages V_{EE} and V_{CC} in Fig. 4. Terminal V_{BP} is connected to the V_{CC} supply. The current-limiting circuit is typically part of a monolithic semiconductor integrated circuit.

Amplifiers A1 and A2 and devices 10 and 14 of Fig. 4 are respectively formed with NPN transistors Q1 and Q2. Devices 10 and 14 also include resistors R1 and R2 in Fig. 4. Device 16 is implemented with an NPN transistor Q3.

Differential amplifier 20 centers around largely identical NPN transistors Q4_{L} and Q4_{R} whose bases receive voltages V_{N1} and V_{N2}. A current source 24 is connected between the V_{EE} supply and the interconnected emitters of transistors Q4_{L} and Q4_{R}. Their collectors are respectively connected to node N3 and the V_{CC} supply. Another current source 26 is connected between node N3 and the V_{CC} supply. Amplifier 20 operates in a conventional manner.

Feedback device 22 consists of a PN-junction diode whose anode and cathode are respectively connected to nodes N3 and N2. The diode is preferably an NPN transistor Q5 having its collector tied back to its base. When signal V_{CTL} goes to the high state, transistor Q5 turns on largely in synchronism with transistor Q3. The positive feedback through transistor Q5 causes V_{N2} to rise slightly due to interaction with transistor Q2.

The following relationships respectively define the operation of devices 10 and 14:${\text{V}}_{\text{REF1}} {\text{- V}}_{\text{BE1}} {\text{- R}}_{\text{1}} {\text{I}}_{\text{ITM}} {\text{= V}}_{\text{N1}}$${\text{V}}_{\text{REF2}} {\text{- V}}_{\text{BE2}} {\text{- R}}_{\text{2}} {\text{I}}_{\text{REF}} {\text{' = V}}_{\text{N2}}$ V_{BE1} and V_{BE2} are the respective base-to-emitter voltages of transistors Q1 and Q2. R₁ and R₂ are the respective resistances of resistors R1 and R2.

The base-to-emitter voltage of an NPN transistor approximately equals kT/q multiplied by the natural logarithm of the collector current divided by the transistor saturation current, where k is Boltzmann's constant, T is the absolute temperature, and q is the electronic charge. Taking note of this along with the approximate current equalities discussed above for Fig. 1, Eqs.(1) and (2) can be converted into:${\text{R}}_{\text{1}} {\text{I}}_{\text{OUT}} {\text{+ (kT/q)1n(I}}_{\text{OUT}} {\text{/I}}_{\text{S1}} {\text{) ≈ V}}_{\text{REF1}} {\text{- V}}_{\text{N1}}$${\text{V}}_{\text{N2}} {\text{≈ V}}_{\text{REF2}} {\text{- R}}_{\text{2}} {\text{I}}_{\text{REF}} {\text{- (kT/q)1n(I}}_{\text{REF}} {\text{/I}}_{\text{S2}} \text{)}$ I_{S1} and I_{S2} are the respective saturation currents for transistors Q1 and Q2. Eq. (3) shows that I_{OUT} increases as the magnitude of the difference between V_{REF1} and V_{N1} increases. Eq. (4) demonstrates how V_{N2} can be calculated as a function of V_{REF2} and I_{REF}.

As mentioned above, I_{IN} equals I_{T} when V_{N1} is nearly equal to V_{N2}. Since I_{OUT} largely equals I_{IN} at that point, Eqs. (3) and (4) can be combined to give the following relationship for the transition point:${\text{I}}_{\text{T}} {\text{+ (kT/qR}}_{\text{1}} {\text{)In(I}}_{\text{S2}} {\text{I}}_{\text{T}} {\text{/I}}_{\text{S1}} {\text{I}}_{\text{REF}} {\text{) ≈(R}}_{\text{2}} {\text{/R}}_{\text{1}} {\text{)I}}_{\text{REF}} {\text{+ (V}}_{\text{REF1}} {\text{- V}}_{\text{REF2}} {\text{)/R}}_{\text{1}}$ V_{REF2} preferably equals V_{REF1}. In addition, the saturation current ratio I_{S2}/I_{S1} substantially equals the emitter area ratio A_{E2}/A_{E1}, where A_{E1} and A_{E2} are the respective emitter areas of transistors Q1 and Q2. Eq. (5) reduces to:${\text{I}}_{\text{T}} {\text{+ (kT/qR}}_{\text{1}} {\text{)1n(A}}_{\text{E2}} {\text{I}}_{\text{T}} {\text{/A}}_{\text{E1}} {\text{I}}_{\text{REF}} {\text{) ≈(R}}_{\text{2}} {\text{/R}}_{\text{1}} {\text{)I}}_{\text{REF}}$

It is usually desirable that the invention be substantially insensitive to changes in temperature. This is achieved in Fig. 4 by choosing the values of circuit parameters in such a way that the parenthetical portion of the logarithmic term in Eq. (6) equals one so that the logarithmic term equals zero. As a result:${\text{I}}_{\text{T}} {\text{/I}}_{\text{REF}} {\text{= A}}_{\text{E1}} {\text{/A}}_{\text{E2}} {\text{≈ R}}_{\text{2}} {\text{/R}}_{\text{1}}$ Resistances R₁ and R₂ vary with temperature. However, the temperature dependencies largely "cancel out" in the ratio R₂/R₁. Eq. (7) thereby establishes the conditions that enable the circuit in Fig. 4 to operate in a substantially temperature independent manner.

In the preferred embodiment, V_{EE} and V_{CC} are nominally 0 and 5 volts. V_{REF1} and V_{REF2} are both 2.5 volts. R₁ and R₂ are both 1,000 ohms. A_{E2} equals A_{E1}. I_{REF} is 200 microamperes. I_{T} and I_{LIM} are about 210 and 220 microamperes. Differential amplifier 20 has a gain of approximately 1,000.

While the invention has been described with reference to particular embodiments, this description is solely for the purpose of illustration and is not to be construed as limiting the scope of the invention claimed before. For example, semiconductor elements of opposite polarity to those described above may be used to achieve the same results. Temperature compensation similar to that described above can be achieved when the invention is implemented with field-effect transistors. Various modifications and applications may be thus made by those skilled in the art without departing from the true scope and spirit of the invention as defined in the appended claims.

## Claims

1. An electronic circuit for preventing an output current (I_{OUT}) flowing through an output line (L_{OUT}) from exceeding a specified value of an input current (I_{IN}) flowing through an input line (L_{IN}), characterized by:
a main channel (10), including the output line (L_{OUT}) and an intermediate line(L_{ITM}) coupled to the input line (L_{IN}) by way of a first node (N1) at which a first nodal voltage (V_{N1}) is present, for providing a current path between the intermediate (L_{ITM}) and output (L_{OUT}) lines, the intermediate line (L_{ITM}) carrying a current substantially equal to the output current;
a current source (12) coupled between a first voltage supply (V_{S1}) and a second node (N2) at which a second nodal voltage (V_{N2}) is present, for supplying a reference current (I_{REF});
a reference channel (14) for providing a current path between the second node (N2) and a second voltage supply (V_{S2}) ;
bypass means (16) coupled to the first node (N1) for providing a current shunt away from the main channel (10); and
control means (18) coupled to the nodes (N1,N2) for supplying the bypass means (16) with a control signal (V_{CTL}) that causes a portion of the input current (I_{IN}) to be diverted away from the intermediate line (L_{ITM}) and through the bypass means (16) when the input current (I_{IN}) achieves a prescribed relationship to the reference current (I_{REF}), the diverted current portion progressively increasing as the input current (I_{IN}) increases such that the output current (I_{OUT}) does not pass the specified value of the input current (I_{IN}).

2. A circuit as in Claim 1 characterized in that:
the main channel (10) comprises a first channel device (10) that causes the output current (I_{OUT}) to vary in a prescribed way as a function of the first nodal voltage (V_{NI}) and a first reference voltage (V_{REF1});
the reference channel (14) comprises a second channel device (14) that substantially sets the second nodal voltages (V_{N2}) at a value dependent on the reference current (I_{REF}) and a second reference voltage (V_{REF2}); and
the control signal (V_{CTL}) switches between a pair of opposite states depending on the amount of difference between the nodal voltages (V_{N1}, V_{N2}).

3. A circuit as in Claim 2 characterized in that the output current (I_{OUT}) increases as the magnitude of the difference between the first nodal voltage (V_{N1}) and the first reference voltage (V_{REF1}) increases.

4. A circuit as in Claim 2 characterized in that generation of the control signal (V_{CTL}) at a selected one of the states causes the bypass means (16) to be disabled, substantially none of the input current (I_{IN}) flowing through the bypass means when it is disabled.

5. A circuit as in Claim 2 characterized in that:
the first channel device (10) comprises a first amplifier (A1) having a first flow electrode coupled to the intermediate line (L_{ITM}), a second flow electrode coupled to the output line (L_{OUT}), and a control electrode responsive to the first reference voltage (V_{REF1}) for controlling current flow between the flow electrodes of the first amplifier (A1); and
the second channel device (14) comprises a second amplifier (A2) having a first flow electrode coupled to the second node (N2), a second flow electrode coupled to the second voltage supply (V_{S2}), and a control electrode responsive to the second reference voltage (V_{REF2}) for controlling current flow between the flow electrodes of the second amplifier (A2).

6. A circuit as in Claim 5 characterized in that:
the first channel device (10) includes a first resistor (R1) coupled between the intermediate line (L_{ITM}) and the first electrode of the first amplifier (A1); and
the second channel device (14) includes a second resistor (R2) coupled between the second node (N2) and the first electrode of the second amplifier (A2).

7. A circuit as in Claim 6 characterized in that the first (A1) and second (A2) amplifiers respectively comprise first (Q1) and second (Q2) like-polarity bipolar transistors, each having an emitter, a collector, and a base respectively coupled to the first, second, and control electrodes of its amplifier.

8. A circuit as in Claim 7 characterized in that: the reference voltages are substantially the same; and R₂/R₁ is substantially equal to A_{E1}/A_{E2}, where R₁ and R₂ are the respective resistances of the first (R1) and second (R2) resistors, and A_{E1} and A_{E2} are the respective areas of the emitters of the first (Q1) and second (Q2) transistors.

9. A circuit as in Claim 5, 6, 7 or 8 characterized in that the control means (18) comprises a differential amplifier (20) having an inverting input for receiving the first nodal voltage (V_{N1}), a non-inverting input for receiving the second nodal voltage (V_{N2}), and an output for supplying the control signal (V_{CTL}) as an amplification of the difference between the nodal voltages (V_{N1},V_{N2}).

10. A circuit as in Claim 9 characterized in that the control means (18) includes feedback means (22) for providing positive feedback from the output of the differential amplifier to its non-inverting input.

11. A circuit as in Claim 9 characterized in that the bypass means (16) comprises a further amplifier (A3) having a first flow electrode coupled to the first node (N1), a second flow electrode coupled to the second voltage supply (V_{S2}), and a control electrode responsive to the control signal (V_{CTL}) for controlling current flow between the flow electrodes of the further amplifier (A3).

## Patentansprüche

1. Elektronische Schaltung, die verhindert, daß ein Ausgangsstrom (I_{OUT}) durch eine Ausgangsleitung (L_{OUT}) einen bestimmten Wert eines Eingangsstroms (I_{IN}) durch eine Eingangsleitung (L_{IN}) überschreitet, gekennzeichnet durch:
einen Hauptkanal (10), der die Ausgangsleitung (L_{OUT}) und eine Zwischenleitung (L_{ITM}) umfaßt, die über einen ersten Knotenpunkt (N1), an dem eine erste Knotenpunktspannung (V_{N1}) anliegt, mit der Eingangsleitung (L_{IN}) verbunden ist, um einen Strompfad zwischen der Zwischenleitung (L_{ITM}) und der Ausgangsleitung (L_{OUT}) zu schaffen, wobei die Zwischenleitung (L_{ITM}) einen Strom führt, der im wesentlichen dem Ausgangsstrom (I_{OUT}) entspricht;
eine Stromquelle (12), die zwischen eine erste Spannungsversorgung (V_{S1}) und einen zweiten Knotenpunkt (N2) geschaltet ist, an dem eine zweite Knotenpunktspannung (V_{N2}) anliegt, um einen Referenzstrom (I_{REF}) zu liefern;
einen Referenzkanal (14), um einen Strompfad zwischen dem zweiten Knotenpunkt (N2) und einer zweiten Spannungsversorgung (V_{S2}) zu schaffen;
Umgehungsmittel (16), die mit den ersten Knotenpunkt (N1) verbunden sind, um einen Strom-Nebenschluß weg vom Hauptkanal (10) zu schaffen und
Steuermitel (18), die mit den Knotenpunkten (N1, N2) verbunden sind, um die Umgehungsmittel (16) mit einem Steuersignal (V_{CTL}) zu versorgen, welches dafür sorgt, daß ein Teil des Eingangsstroms (I_{IN}) von der Zwischenleitung (L_{ITM}) abgezweigt und durch das Umgehungsmittel (16) geleitet wird, wenn der Eingangsstrom (I_{IN}) ein vorgegebenes Verhältnis zu dem Referenzstrom (I_{REF}) erreicht, wobei der abgezweigte Stromanteil fortschreitend mit dem Anstieg des Eingangsstroms (I_{IN}) zunimmt, so daß der Ausgangsstrom (I_{OUT}) den spezifizierten Wert des Eingangsstroms (I_{IN}) nicht überschreitet.

2. Schaltung nach Anspruch 1, dadurch gekennzeichnet, daß
der Hauptkanal (10) eine erste Kanalvorrichtung (10) umfaßt, die dafür sorgt, daß der Ausgangsstrom (I_{OUT}) in vorgeschriebener Weise als Funktion der ersten Knotenpunktspannung (V_{N1}) und einer ersten Referenzspannung (V_{REF1}) schwankt;
der Referenzkanal (14) eine zweite Kanalvorrichtung (14) umfaßt, die die zweite Knotenpunktspannung (V_{N2}) im wesentlichen auf einen Wert einstellt, der von dem Referenzstrom (I_{REF}) und einer zweiten Referenzspannung (V_{REF2}) abhängt; und daß
das Steuersignal (V_{CTL}) abhängig von der Größe der Differenz zwischen den Knotenpunktspannungen (V_{N1}, V_{N2}) zwischen einem Paar von entgegengesetzten Zuständen umschaltet.

3. Schaltung nach Anspruch 2, dadurch gekennzeichnet, daß der Ausgangsstrom (I_{OUT}) zunimmt, wenn die Größe der Differenz zwischen der ersten Knotenpunktspannung (V_{N1}) und der ersten Referenzspannung (V_{REF1}) zunimmt.

4. Schaltung nach Anspruch 2, dadurch gekennzeichnet, daß durch die Erzeugung des Steuersignals (V_{CTL}) bei einem der Zustände dazu führt, daß das Umgehungsmittel (16) deaktiviert wird, wobei im wesentlichen kein Teil des Eingangsstroms (I_{IN}) durch das deaktivierte Umgehungsmittel fließt.

5. Schaltung nach Anspruch 2, dadurch gekennzeichnet, daß:
die erste Kanalvorrichtung (10) einen ersten Verstärker (A1) umfaßt, dessen erste Leitungselektrode mit der Zwischenleitung (L_{ITM}) verbunden ist, dessen zweite Leitungselektrode mit der Ausgangsleitung (L_{OUT}) verbunden ist und dessen Steuerelektrode auf die erste Referenzspannung (V_{REF1}) reagiert, um den Stromfluß zwischen den Leitungselektroden des ersten Verstärkers (A1) zu steuern; und daß
die zweite Kanalvorrichtung (14) einen zweiten Verstärker (A2) umfaßt, dessen erste Leitungselektrode mit dem zweiten Knotenpunkt (N2) verbunden ist, dessen zweite Leitungselektrode mit der zweiten Spannungsversorgung (V_{S2}) verbunden ist und dessen Steuerelektrode auf die zweite Referenzspannung (V_{REF2}) reagiert, um den Stromfluß zwischen den Leitungselektroden des zweiten Verstärkers (A2) zu steuern.

6. Schaltung nach Anspruch 5, dadurch gekennzeichnet, daß:
die erste Kanalvorrichtung (10) einen ersten Widerstand (R1) umfaßt, der zwischen die Zwischenleitung (L_{ITM}) und die erste Elektrode des ersten Verstärkers (A1) geschaltet ist; und daß
die zweite Kanalvorrichtung (14) einen zweiten Widerstand (R2) umfaßt, der zwischen den zweiten Knotenpunkt (N2) und die erste Elektrode des zweiten Verstärkers (A2) geschaltet ist.

7. Schaltung nach Anspruch 6, dadurch gekennzeichnet, daß der erste Verstärker (A1) und der zweite Verstärker (A2) einen ersten (Q1) bzw. einen zweiten bipolaren Transistor (Q2) gleicher Polarität umfassen, deren Emitter, Kollektor und Basis jeweils mit der ersten Leitungselektrode, der zweiten Leitungselektrode bzw. der Steuerelektrode des Verstärkers verbunden sind.

8. Schaltung nach Anspruch 7, dadurch gekennzeichnet, daß die Referenzspannungen im wesentlichen gleich sind und daß R₂/R₁ im wesentlichen gleich A_{E1}/A_{E2} ist, wobei R₁ und R₂ die jeweiligen Widerstandswerte des ersten (R1) bzw. des zweiten Widerstandes (R2) sind und wobei A_{E1} und A_{E2} die jeweiligen Emitterflächen des ersten (Q1) bzw. des zweiten Transistors (Q2) darstellen.

9. Schaltung nach Anspruch 5, 6, 7 oder 8, dadurch gekennzeichnet, daß das Steuermittel (18) einen Differenzverstärker (20) enthält mit einem invertierenden Eingang, dem die erste Knotenpunktspannung (V_{N1}) zugeführt wird, mit einem nicht-invertierenden Eingang, dem die zweite Knotenpunktspannung (V_{N2}) zugeführt wird, und mit einem Ausgang, der das Steuersignal (V_{CTL}) als Verstärkung der Differenz zwischen den beiden Knotenpunktspannungen (V_{N1}, V_{N2}) liefert.

10. Schaltung nach Anspruch 9, dadurch gekennzeichnet, daß das Steuermittel (18) Rückkopplungsmittel (22) für eine positive Rückkopplung vom Ausgang des Differenzverstärkers zu seinem nicht-invertierenden Eingang umfaßt.

11. Schaltung nach Anspruch 9, dadurch gekennzeichnet, daß das Umgehungsmittel (16) einen weiteren Verstärker (A3) umfaßt, dessen erste Leitungselektrode mit dem ersten Knotenpunkt (N1) verbunden ist, dessen zweite Leitungselektrode mit der zweiten Spannungsversorgung (V_{S2}) verbunden ist und dessen Steuerelektrode auf das Steuersignal (V_{CTL}) reagiert, um den Stromfluß zwischen den Leitungselektroden des weiteren Verstärkers (A3) zu steuern.

## Revendications

1. Circuit électronique servant à empêcher un courant de sortie (I_{OUT}) circulant à travers une ligne de sortie (L_{OUT}) de dépasser une valeur spécifiée d'un courant d'entrée (I_{IN}) circulant à travers une ligne d'entrée (L_{IN}), caractérisé par :
un canal principal (10), incluant la ligne de sortie (L_{OUT}) et une ligne intermédiaire (L_{IN}) couplée à la ligne d'entrée (L_{IN}) à l'aide d'un premier noeud (N1) auquel une première tension nodale (V_{N1}) est appliquée, afin de fournir un chemin de courant entre la ligne intermédiaire (L_{ITM}) et la ligne de sortie (L_{OUT}), la ligne intermédiaire (L_{ITM}) transportant un courant pratiquement égal au courant de sortie;
une source de courant (12), couplée entre une première source de tension (V_{S1}) et un second noeud (N2) auquel est appliquée une seconde tension nodale (V_{N2}), afin de fournir un courant de référence (I_{REF});
un canal de référence (14) afin de fournir un chemin de courant entre le second noeud (N2) et une seconde source de tension (V_{S2});
un dispositif de by-pass (16) couplé au premier noeud (N1) afin de dévier une partie du courant du canal principal (10), et
un moyen de commande (18) couplé aux noeuds (N1, N2) afin de fournir au dispositif de by-pass (16) un signal de commande (V_{CTL}) qui provoque la déviation d'une partie du courant d'entrée (I_{IN}) de la ligne intermédiaire (L_{ITM}) vers le dispositif de by-pass (16) lorsque le courant d'entrée (I_{IN}) atteint une relation prédéfinie par rapport au courant de référence (I_{REF}), la partie de courant déviée augmentant progressivement lorsque le courant d'entrée (I_{IN}) augmente, de telle sorte que le courant de sortie (I_{OUT}) ne dépasse pas la valeur spécifiée du courant d'entrée (I_{IN}).

2. Circuit suivant la revendication 1, caractérisé en ce que :
le canal principal (10) comprend un premier dispositif de canal (10) qui force le courant de sortie (I_{OUT}) à varier de manière prescrite en fonction de la première tension nodale (V_{N1}) et d'une première tension de référence (V_{REF1});
le canal de référence (14) comprend un second dispositif de canal (14) qui met pratiquement la seconde tension nodale (V_{N2}) à une valeur dépendant du courant de référence (I_{REF}) et d'une seconde tension de référence (V_{REF2}), et
le signal de commande (V_{CTL}) commute entre une paire de niveaux opposés dépendant de l'amplitude de la différence entre les tensions nodales (V_{N1}, V_{N2}).

3. Circuit suivant la revendication 2, caractérisé en ce que le courant de sortie (I_{OUT}) augmente lorsque l'amplitude de la différence entre la première tension nodale (V_{N1}) et la première tension de référence (V_{REF1}) augmente.

4. Circuit suivant la revendication 2, caractérisé en ce que la génération du signal de commande (V_{CTL}) à un des deux niveaux donnés provoque la désactivation du dispositif de by-pass (16), la quantité du courant d'entrée (I_{IN}) circulant à travers le dispositif de by-pass (16) étant pratiquement nulle lorsque celui-ci est désactivé.

5. Circuit suivant la revendication 2, caractérisé en ce que :
le premier dispositif de canal (10) comprend un premier amplificateur (A1) ayant une première électrode de courant couplée à la ligne intermédiaire (L_{ITM}), une seconde électrode de courant couplée à la ligne de sortie (L_{OUT}) et une électrode de commande sensible à la première tension de référence (V_{REF1}) pour commander la circulation de courant entre les électrodes de courant du premier amplificateur (A1), et
le second dispositif de canal (14) comprend un second amplificateur (A2) ayant une première électrode de courant couplée au second noeud (N2), une seconde électrode de courant couplée à la seconde tension d'alimentation (V_{S2}) et une électrode de commande sensible à la seconde tension de référence (V_{REF2}) pour commander la circulation de courant entre les électrodes de courant du second amplificateur (A2).

6. Circuit suivant la revendication 5, caractérisé en ce que :
le premier dispositif de canal (10) comprend une première résistance (R₁) couplée entre la ligne intermédiaire (L_{ITM}) et la première électrode du premier amplificateur (A1), et
le second dispositif de canal (14) comprend une seconde résistance (R₂) couplée entre le second noeud (N2) et la première électrode du second amplificateur (A2).

7. Circuit suivant la revendication 6, caractérisé en ce que le premier (A1) et le second amplificateur (A2) comprennent respectivement un premier (Q1) et un second (Q2) transistor bipolaire de même configuration, chacun ayant un émetteur, un collecteur et une base couplés respectivement à la première électrode, la seconde électrode et l'électrode de commande de son amplificateur.

8. Circuit suivant la revendication 7, caractérisé en ce que :
les tensions de référence sont pratiquement les mêmes, et en ce que R₂/R₁ sont pratiquement égales à A_{E1}/A_{E2}, où R₁ et R₂ sont les valeurs de résistance respectivement de la première (R₁) et de la seconde (R₂) résistance, et A_{E1} et A_{E2} sont les surfaces d'émetteurs respectives du premier (Q1) et du second (Q2) transistor.

9. Circuit suivant la revendication 5, 6, 7 ou 8, caractérisé en ce que le moyen de commande (18) comprend un amplificateur différentiel (20) ayant une entrée inversée à laquelle est appliquée la première tension nodale (V_{N1}), une entrée non inversée à laquelle est appliquée la seconde tension nodale (V_{N2}), et une sortie fournissant le signal de commande (V_{CTL}) comme amplification de la différence entre les tensions nodales (V_{N1}, V_{N2}).

10. Circuit suivant la revendication 9, caractérisé en ce que le moyen de commande (18) comprend un moyen de rétroaction (22) fournissant une rétroaction positive de la sortie de l'amplificateur différentiel vers son entrée non inversée.

11. Circuit suivant la revendication 9, caractérisé en ce que le dispositif de by-pass (16) comprend un amplificateur différentiel supplémentaire (A3) ayant une première électrode de courant couplée au premier noeud (N1), une seconde électrode de courant couplée à la seconde source de tension (V_{S2}) et une électrode de commande sensible au signal de commande (V_{CTL}) afin de commander la circulation de courant entre les électrodes de courant de l'amplificateur supplémentaire (A3).
